# FASCICULE DE BREVET EUROPEEN

(11) **EP 2 545 503 B1**
(45) Date de publication et mention de la délivrance du brevet: **18.12.2013**
(21) Numéro de dépôt: 11712974.2
(22) Date de dépôt: 07.03.2011
(51) Int. Cl.: G06K 19/07, G06K 19/077, H01L 23/498

(54) **DISPOSITIF ÉLECTRONIQUE À PUCE ET PROCÉDÉ DE FABRICATION PAR BOBINES**
ELEKTRONISCHE VORRICHTUNG MIT EINEM CHIP UND HERSTELLUNGSVERFAHREN MITTELS SPULEN
ELECTRONIC DEVICE HAVING A CHIP AND METHOD FOR MANUFACTURING BY COILS

(30) Priorité: 08.03.2010 FR 1000926
(43) Date de publication de la demande: 16.01.2013
(73) Titulaire: Smartflex Innovation Pte. Ltd., Singapore 408618 (SG)
(72) Inventeur: ORMEROD, Simon, F-13600 La Ciotat (FR); SALVAGIONE, Alain, F-13112 La Destrousse (FR); ELBAZ, Didier, F-13010 Marseille (FR)
(74) Mandataire: Hirsch & Associés
(86) Numéro de dépôt international: PCT/FR2011/050467
(87) Numéro de publication internationale: WO 2011/110781

(56) Documents cités:
- EP-A1- 0 307 773
- WO-A1-00/65689
- US-A1- 2003 226 901
- US-A1- 2008 205 012

## Description

La présente invention concerne le domaine des dispositifs à puce et plus particulièrement les dispositifs électronique à puce comportant une interface de communication avec ou sans contact.

La présente invention propose un objet à dispositif électronique à puce et son procédé de fabrication:

Dans l'art antérieur, les dispositifs électroniques à puce tels que les mini cartes SIM sont généralement constitués à partir d'une carte à puce de taille standard. La carte standard est composée d'un mini-boîtier ou d'un module comportant un bornier de contact auquel sont reliées les bornes d'une puce.

Les différentes opérations mises en oeuvre pour assembler le mini-boîtier ou le module et fabriquer le dispositif électronique se font de manière unitaire. Un wafer de silicium est scié pour individualiser chaque puce. Chaque puce est alors fixée unitairement selon la technologie de connexion filaire (*wire bonding* en anglais) ou la technologie de la puce retournée (*Flip-chip* en anglais).

Dans la technologie de connexion filaire dite aussi de pastillage, la puce est fixée sur un film avec sa plage de contact orientée vers l'extérieur. Un câblage entre la plage de contact de la puce et un bornier ou une antenne est alors réalisé. Enfin, une encapsulation de l'ensemble est effectuée grâce à une résine pour protéger l'ensemble.

Dans la technologie de la puce retournée, la puce est fixée avec sa plage de contact orientée vers le film sur une face conductrice reliée à un bornier par des trous d'interconnexion.

En outre, après la création du mini-boîtier ou du module, celui-ci doit être suffisamment rigide et épais pour permettre les manipulations des opérations d'encartage qui sont nécessaires pour réaliser le produit fini. Un adhésif thermoactivable peut être déposé sur chaque mini-boîtier ou module pour pouvoir être collé dans un corps de carte par laminage à chaud sur le film.

Le corps de carte constitué d'une ou plusieurs feuilles laminées doit comporter une cavité usinée ou directement injectée afin de recevoir le micro-boîtier ou le module. Chaque micro-boîtier ou module est alors fixé dans la cavité de chaque corps de carte soit par l'adhésif déposé qui peut être thermoactivable par pressage à chaud, soit en utilisant une colle liquide dispensée dans la cavité.

La carte est alors découplée mécaniquement pour récupérer uniquement la forme du produit fini.

Ces opérations faites de manière unitaire possèdent plusieurs inconvénients. En effet, pour ce procédé, un grand nombre d'opérations et de machines sont nécessaires. De part la fixation de façon unitaire de chaque puce, la productivité n'est pas optimisée. En outre, des matériaux onéreux sont utilisés avec de grandes pertes. Notamment, le film doit avoir des métallisations compatibles pour une soudure avec des fils d'or reliés aux plots de la puce. Ces métallisations de type nickel et or doivent être réalisées sur les deux faces du film. De plus, le film impose des investissements en outillage spécifique comme des outils de découpe du diélectrique ou de photogravure amenant à un manque de flexibilité. Tout au long du circuit des opérations de fabrication pour arriver à une dimension de produit fini, une perte importante de matière tel que le film et le corps de carte peut atteindre plus de 60 %.

En outre, il est nécessaire d'utiliser un film très onéreux pour être compatible avec les étapes de fixation de la puce. Car, les dimensions et la rigidité du film doivent permettre sa manipulation et son collage.

De plus, les procédés exposés ne proposent pas de solutions simples et économiques pour protéger la puce des contraintes mécaniques telles que l'appui des picots d'un lecteur externe sur le bornier. La puce étant un composant très fragile, une mauvaise manipulation ou utilisation peut la détruire.

Le brevet US 2008/0205012 A1 décrit un module de carte à puce comprenant un substrat et des tracés conducteurs qui sont appliqués sans adhésif sur au moins une surface du substrat. Une puce est agencée sur une surface du substrat et connectée électriquement aux tracés conducteurs. Une coiffe encapsule au moins une partie de la puce est des tracés conducteurs. Ce document ne donne pas de solutions économiques pour protéger la puce des contraintes mécaniques telles que l'appui des picots d'un lecteur externe sur le bornier et les tracés conducteurs sont réalisés à partir d'une couche de nickel-or qui n'est pas un matériau économique.

Le brevet WO 00/65689 enseigne un objet sans-fil, telle qu'une étiquette ou un badge d'identification comprenant une puce. Cet objet sans-fil possède une antenne à spires sur une surface d'un substrat pour recevoir et/ou envoyer des signaux de fréquences radio. De la même manière qué le document précédent, ce document ne donne pas de solutions économiques pour protéger la puce des contraintes mécaniques telles que l'appui des picots d'un lecteur externe sur le bornier et les tracés conducteurs sont réalisés à partir d'une couche de nickel-or.

Le brevet EP 0 307 773 enseigne un procédé de fabrication de modules électroniques pour cartes à microcircuits. Le module électronique fabriqué par ce procédé comporte une première unité qui comporte un premier substrat isolant recouvert par des électrodes sous chacune desquelles se trouve un premier trou. Le module comprend en outre une seconde unité qui comporte une puce dont les bornes de connexion sont reliées à des conducteurs imprimés sur un second substrat isolant. Une des extrémités libres de chaque conducteur tombe au droit d'un second trou pratiqué-dans le second substrat isolant. Les deux unités sont superposée de telle manière que chaque Premier trou est coaxial à chaque second trou. Les extrémités libres des conducteurs de la seconde unité sont soudées aux électrodes de la première unité. La soudure est Pratiquée en introduisant un outil de soudage dans les seconds trous. Ce document ne donne pas de solutions simples et économiques pour protéger la puce des contraintes mécaniques telles que l'appui des picots d'un lecteur externe sur le bornier.

Le brevet US 2003/0226901 enseigne une carte à puce « combi » à contact et sans contact et son procédé de fabrication. Pour la fabrication de la carte, une couche conductrice est appliquée sur une substrat isolant. Cette couche conductrice est alors gravée pour gréer une antenne, une plage de contact agencée pour monter une puce et une zone de fixation pour monter un bornier de connexion externe permettant de recevoir les picots d'un lecteur par exemple. Toutes les plages de contact sont situées sur une seule face. Ce document ne donne pas de solutions simples et économiques pour protéger la puce des contraintes mécaniques telles Que l'appui des picots d'un lecteur externe sur le bornier.

La présente invention a pour but de donner une solution technique à ces inconvénients en proposant un procédé de fabrication et un dispositif électronique à puce selon le procédé de fabrication.

Pour atteindre ce but, le dispositif électronique à puce comporte au moins :
- un module électronique comportant au moins :
   - un film support souple, dont les dimensions correspondent à une des dimensions du dispositif électronique dont la surface supérieure possède une plage de contact supérieure et dont la surface inférieure possède au moins une plage de contact inférieure, chaque plage de contact étant prolongée par des conducteurs reliés par interconnexion à travers le film support dans une zone d'interconnexion de telle façon qu'au moins une plage de contact inférieure est reliée à la plage de contact supérieure, la ou les plages de contact inférieures intersectant le périmètre destiné à être occupé par au moins une puce reliée selon la technologie de la puce retournée à chaque plage de contact inférieure et la ou les plages de contact inférieures étant décalées par rapport à la zone du film support en vis-à-vis de la zone dont le périmètre encercle la plage de contact supérieure ; la ou les plages de contact de la surface inférieure et supérieure et les conducteurs étant en matériau conducteur sans composant onéreux tel que le nickel ou l'or;
- un film épais, pourvu d'au moins une cavité en vis-à-vis de la zone où la puce du film support vient en vis-à-vis, et fixé sur au moins une partie de la surface du film support du côté de la puces.

Selon une autre particularité, le dispositif électronique à puce est une carte à puce dont la plage de contact supérieure est un bornier agencé selon la norme ISO 7816 avec des plages de contact en aluminium, en argent ou en cuivre pour se connecter à un lecteur externe.

Selon une autre particularité, le dispositif électronique à puce est un objet intelligent dont la plage de contact supérieure est un bornier agencé selon la norme adaptée à l'objet intelligent.

Selon une autre particularité, le dispositif électronique à puce comporte en outre une antenne RFID apte à se connecter par communication par radiofréquence à un lecteur externe, l'antenne RFID étant située sur la surface inférieure.

Selon une autre particularité, la plage de contact supérieure communique avec une puce dédié au bornier, l'antenne RFID communiquant avec une puce spécifique à l'antenne RFID.

Selon une autre particularité, la plage de contact supérieure et l'antenne RFID communiquent avec une puce possédant un dispositif d'interprétation qui détermine si la puce est en configuration de communication avec la plage de contact supérieure ou avec l'antenne RFID.

Selon une autre particularité, les plots de contact de la ou des puces sont orientés vers la ou les plages de contact dédiées à la ou les puces de la surface inférieure.

Selon une autre particularité, le film support est en matière plastique PVC, PC, PET, PETF, PETG, PP, PS, PPS, en papier ou en matière végétale pouvant être laminée et extrudée à des épaisseurs sensiblement égales à 150 µm ou une combinaison de ces matières, l'épaisseur du film (3) étant préférentiellement sensiblement égale à 50 µm.

Selon une autre particularité, le film épais est constitué d'une ou plusieurs couches en PVC, en ABS, en PET, PETF, PETG, PP, PS, PPS ou toute autre matière autorisant un travail en bobine, ou en bois, ou en carton ou en bioplastique.

Selon une autre particularité, les plages de contact et les conducteurs des surfaces supérieure et inférieure sont en aluminium ou en cuivre.

Selon une autre particularité, le film support a au moins deux côté parallèles ou adjacents de longueur égale aux côtés parallèles ou adjacents du dispositif électronique à puce.

Selon une autre particularité, la zone d'interconnexion est décalée par rapport à la plage de contact supérieure ou la plage de contact inférieure et à l'extérieur du périmètre destiné à la ou aux puces.

Selon une autre particularité, la zone d'interconnexion est décalée par rapport à la plage de contact supérieure ou la plage de contact inférieure et par rapport à l'antenne RFID ainsi qu'à l'extérieur du périmètre destiné à la ou aux puces.

Un autre but est atteint en proposant un procédé de fabrication du dispositif électronique à puce selon l'invention.

Ce procédé est caractérisé en ce que un film support est alimenté en continu par au moins une bobine fournissant une bande de largeur au moins égale à un multiple d'une des dimensions du dispositif électronique à puce, les deux surfaces de la bande de la bobine de film support comportant une série de circuits conducteurs individuels pour une pluralité de dispositifs électronique à puce, chaque circuit individuel étant réalisé de telle façon que la surface supérieure possède une première plage de contact et que la surface inférieure possède au moins une deuxième plage de contact, chaque plage de contact étant prolongée par des conducteurs vers une zone d'interconnexion de telle façon qu'au moins une plage de contact inférieure est reliée à la plage de contact supérieure, la ou les plages de contact inférieures intersectant le périmètre destiné à être occupé par les contacts d'une puce reliée électriquement à chaque plage de contact inférieure et la ou les plages de contact inférieures étant décalées par rapport à la zone du film support en vis-à-vis de la zone dont le périmètre encercle la plage de contact supérieure, et en ce qu'il comporte au moins les étapes suivantes :
- une étape de réalisation dans la zone d'interconnexion d'une pluralité de trous d'interconnexion à travers le film support ;
- une étape de connexion de la plage de contact supérieure et de la ou des plages de contact inférieures par les trous d'interconnexion ;
- une étape de dépôt d'une colle conductrice anisotropique sur une pluralité de zones de ou des plages de contact inférieures de la bande de la bobine du film support destinées à recevoir une puce ;
- une étape de fixation sur la bande de la bobine du film support d'au moins une puce sur la ou les zones destinées à recevoir une puce ;
- une étape de mise en bobine(s) de la bande du film support avec les puces fixées ;
- une étape d'emboutissage ou de découpe d'une bande du film épais de même largeur que la bande ou une des dimensions du dispositif électronique pour obtenir une ou des cavités réalisées aux emplacements des puces ;
- une étape d'amenée en superposition des deux bandes et d'adhésion ou de collage de la bande de la bobine du film épais sur la bande de la bobine du film support avec les puces fixées.

Selon une autre particularité, l'étape d'adhésion ou de collage de la bande de la bobine du film épais sur la bande de la bobine du film support avec les puces fixées est suivie ou précédée d'une étape de dépôt d'une protection mécanique et/ou optique de la puce.

Selon une autre particularité, l'étape de connexion de la plage de contact supérieure et de la ou des plages de contact inférieures par les trous d'interconnexion consiste en une connexion par encrage mécanique ou rivetage, par soudure ultrasonique ou thermique ou par remplissage du trou d'interconnexion par un élément conducteur.

Selon une autre particularité, l'étape de fixation sur la bande de la bobine du film support de la ou des puces consiste en une fixation de la ou des puces par la technologie de la puce retournée *(Flip-Chip).*

Selon une autre particularité, l'étape de fixation sur la bande de la bobine du film support d'une pluralité de puces est suivie d'une étape de test et/ou de pré-personnalisation des puces.

Selon une autre particularité, l'étape de réalisation d'une pluralité de trous d'interconnexion à travers la bande de la bobine du film support est précédée d'une étape de dépôt d'un film adhésif sur toute la surface inférieure de la bande de la bobine du film support.

Selon une autre particularité, l'étape d'emboutissage ou de découpe de la bande de la bobine du film épais est précédée ou suivie d'une étape de dépôt d'un film adhésif sur la surface de la bande de la bobine du film épais destinée à être fixée sur la bande de la bobine du film support.

Selon une autre particularité, l'étape d'emboutissage ou de découpe de la bande de la bobine du film épais et/ou l'étape de dépôt d'un film adhésif sur la surface de la bande de la bobine du film épais sont précédées d'une étape de dépôt d'une protection sur les surfaces dé la bande de la bobine du film épais.

Selon une autre particularité, l'étape d'emboutissage ou de découpe de la bande de la bobine du film épais et/ou l'étape de dépôt d'un film adhésif sur la surface de la bande de la bobine du film épais et/ou l'étape de dépôt d'une protection sont précédées d'une étape de pré-personnalisation sur au moins une des surfaces de la bande de la bobine du film épais par impression ou par gravure.

Selon une autre particularité, l'étape d'emboutissage ou de découpe de la bande de la bobine du film épais est suivie d'une étape d'impression d'un élément sécuritaire ou cosmétique par gravure ou par impression sur au moins une des surfaces de la bande de la bobine du film épais, l'élément sécuritaire ou cosmétique étant visible sur le dispositif (0) électronique à puce si le film (3) support est en matière transparente.

Selon une autre particularité, l'étape de dépôt d'une protection mécanique et/ou optique de la pluralité de puces est éventuellement suivie d'une étape de personnalisation électrique de la ou des puces à l'aide d'une carte à picots ou d'un dispositif à antenne sans contact connectés à un lecteur encodeur externe.

Selon une autre particularité, l'étape de personnalisation électrique de la ou des puces à l'aide d'une carte à picots connecté à un lecteur externe est éventuellement suivie d'une étape du personnalisation du dispositif électronique à puce(s) par gravure ou par impression ou par transfert thermique sur la face de la bande de la bobine du film épais qui n'est pas fixée de la bande de la bobine du film support.

Selon une autre particularité, l'étape de dépôt d'une protection mécanique et/ou optique de la pluralité de puces est suivie d'une étape de personnalisation du dispositif électronique à puce(s) par gravure ou par impression ou par transfert thermique sur la face inférieure de la bande de la bobine du film support qui n'est pas fixée sur le film support.

Selon une autre particularité, l'étape de personnalisation du dispositif électronique à puce(s) par gravure ou par impression ou par transfert thermique sur la face inférieure de la bande de la bobine du film support est réalisée à n'importe quel moment après l'étape de fixation sur la bande de la bobine du film support de la ou des puces.

Selon une autre particularité, l'étape de personnalisation du dispositif électronique à puce(s) par gravure ou par impression ou par transfert thermique sur la face inférieure de la bande de la bobine du film support est suivie d'une étape de personnalisation du dispositif électronique à puce(s) par gravure ou par impression ou par transfert thermique sur la face de la bande de la bobine du film épais qui n'est pas fixée de la bande de la bobine du film support.

Selon une autre particularité, l'étape de dépôt d'une protection mécanique et/ou optique de la pluralité de puces est suivie d'une étape de mise en bobine de la bande de la bobine du film support et de la bande de la bobine du film épais assemblés selon les étapes précédentes.

Selon une autre particularité, l'étape de dépôt d'une protection mécanique et/ou optique de la pluralité de puces est suivie d'une étape de découpe de la bande de la bobine du film support et de la bande de la bobine du film épais assemblés selon les étapes précédentes en dispositifs électronique à puce(s) individuels.

Selon une autre particularité, l'étape de découpe est suivie d'une étape de conditionnement des dispositifs électronique à puce(s) découpés.

Un autre but de l'invention est une machine permettant la mise en oeuvre du procédé selon l'invention.

Cette machine est caractérisée en ce qu'elle comporte au moins les dispositifs suivants :
- un dispositif de débobinage d'une bande de film support pourvu de pistes conductrices sur les deux faces ;
- un dispositif d'emboutissage mécanique ou ultrasonique de trous d'interconnexion ;
- un dispositif de dépôt de colle ou de film adhésif sur une pluralité de zones de ou des plages de contacts inférieures destinées à recevoir une puce ;
- un dispositif de dépôt de puce(s);
- un dispositif de pressage et réticulation de la colle ou d'activation du film adhésif ;
- un dispositif d'enroulement en bobine de la bande du film avec les puces de telle façon que les puces soient à l'extérieures ;
- un dispositif d'emboutissage disposé en vis-à-vis de la face de la bande du film épais qui est la face de jonction avec le film support ;
- un dispositif (207) de liaison des deux films épais et support.

Selon une autre particularité, la machine est composée en outre d' :
- un dispositif de déroulement d'une bande de film support avec puces ;
- un dispositif de déroutement d'un film épais ;
- un dispositif de dépôt d'un élément sécuritaire ou cosmétique ;
- un dispositif de dépôt par laminage de protection mécanique et/ou optique des puces ;
- un dispositif de découpe en dispositifs électroniques à puce individuels.

Selon une autre particularité, la machine est composée en outre d'un dispositif de dépôt d'un adhésif ou d'une préparation de surface.

Selon une autre particularité, la machine est composée en outre d'un dispositif de test et de pré-personnalisation des puces.

Selon une autre particularité, la machine est composée en outre d'un dispositif de pré-personnalisation graphique sur au moins une des faces du film épais.

Selon une autre particularité, la machine est composée en outre d'un dispositif de dépôt d'une couche de protection par laminage.

Selon une autre particularité, la machine est composée en outre d'un dispositif de personnalisation sur la face du film épais qui est la face opposée à la face de jonction avec le film support et/ou sur la face du film support qui est la face opposée à la face de jonction avec le film épais.

D'autres particularités et avantages de la présente invention apparaîtront plus clairement à la lecture de la description ci-après, faite en référence aux dessins annexés, dans lesquels :
- la figure 1 représente une vue de dessus d'un dispositif électronique à puce selon une configuration ;
- la figure 2 représente une coupe A-A du dispositif électronique à puce selon une configuration ;
- la figure 3 représente une vue partiellement éclatée du dispositif électronique à puce selon une configuration ;
- la figure 4 représente une vue de dessus d'un dispositif électronique à puce selon une autre configuration avec une antenne RFID ;
- la figure 5 représente une vue de dessus d'un dispositif électronique à puce selon une autre configuration avec une antenne RFID ;
- la figure 6 représente schématiquement la machine selon une configuration mettant en oeuvre les premières étapes du procédé de fabrication du dispositif électronique à puce(s) ;
- la figure 7 représente schématiquement la machine selon une configuration mettant en oeuvre les étapes suivant les premières étapes du procédé de fabrication du dispositif électronique à puce(s).

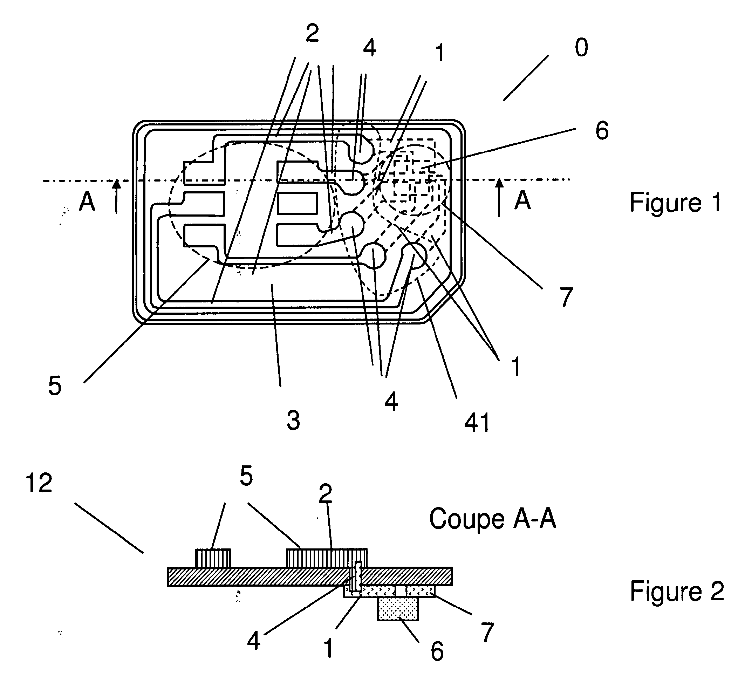

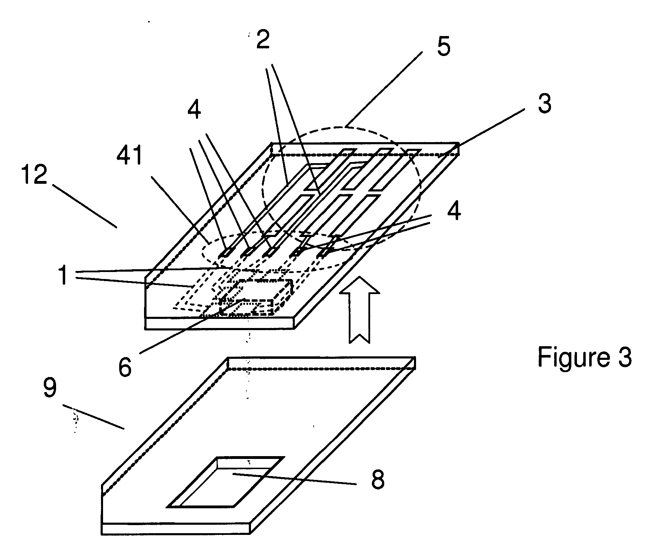

En référence aux figures 1, 2 et 3, l'invention concerne un dispositif électronique à microcircuit intégré, par exemple, de type intelligent à microprocesseur ou logique de traitement en général à semi-conducteur de type silicium ou plastique appelé aussi puce comportant au moins un module électronique est un film (9) épais fixé sur le module électronique. Le dispositif électronique à puce peut être une carte à puce, une carte SIM, une mini carte SIM utilisée pour les téléphones portables de type GSM, une carte sans contact ou une carte hybride qui possède des moyens de lecture avec et sans contact ou un objet intelligent (*SmartObject*) tel que, par exemple, les cartes SD, mini / micro SD, MMC, VQFN8, SSOP20, TSSOP20, MemorySticks, etc.

Dans la suite de la description, il sera fait référence à une mini carte SIM mais il doit être compris que cela peut être appliquée pour les dispositifs listés précédemment.

Le module (12) électronique comporte au moins un film (3) support souple, peu onéreux, de dimension correspondant à la dimension en largeur du dispositif (0) électronique à puce. Le film support a une souplesse autorisant un travail en bobine. Il est assez souple pour qu'il puisse être enroulé en bobine.

La surface supérieure du film (0) support possède une plage (5) de contact supérieure. Cette plage (5) de contact supérieure est constituée de plots formant un bornier. De préférence, pour une carte à puce, le bornier est agencé selon la norme ISO 7816 et est capable de se connecter à un lecteur externe comportant des picots de contact s'appuyant sur au moins un plot du bornier. Chaque plot de la plage (5) de contact supérieure est prolongé par des conducteurs (2) qui se dirigent chacun vers un trou (4) d'interconnexion différent ou identique d'une zone (41) d'interconnexion. La zone (41) d'interconnexion est décalée par rapport à la plage (5) de contact supérieure ou la plage (7) de contact inférieure et à l'extérieur du périmètre destiné à la ou aux puces. Le bornier peut également être agencé selon des normes adaptées aux objets intelligents tels que, par exemple, les cartes SD, mini / micro SD, MMC, VQFN8, SSOP20, TSSOP20, MemorySticks, etc. Ces normes sont définies par des associations de fabricant des objets intelligents (norme, MMC, norme SD, norme SDHC, norme SDXC, etc.)

La surface inférieure du film (3) support possède au moins une plage de contact inférieure. La ou les plages de contact sont constituées de plots. Chaque plage de contact occupent une zone qui intersecte avec le périmètre destiné à être occupé par une puce (4) qui est dédiée à chaque plage dé contact inférieure. La ou les zones occupées par la ou les plages (7) de contact inférieures sont décalées par rapport à la zone en vis-à-vis de la plage (5) de contact supérieure. La ou les plages (7) de contact inférieures sont constituées de plots destinés à être connectés aux plots de la puce (4) qui lui est dédiée.

Selon une configuration, la surface inférieure possède une plage de contact inférieure possédant des plots qui sont prolongés par des conducteurs (1) qui se dirigent chacun vers un trou (4) d'interconnexion différent ou identique d'une zone (41) d'interconnexion pour se connecter aux conducteurs (2) prolongeant les plots de la plage (5) de contact supérieure. Une puce (4) est fixée sur la plage de contact inférieure. La zone (41) d'interconnexion est décalée par rapport à la plage (5) de contact supérieure ou la plage (7) de contact inférieure et à l'extérieur du périmètre destiné à la ou aux puces.

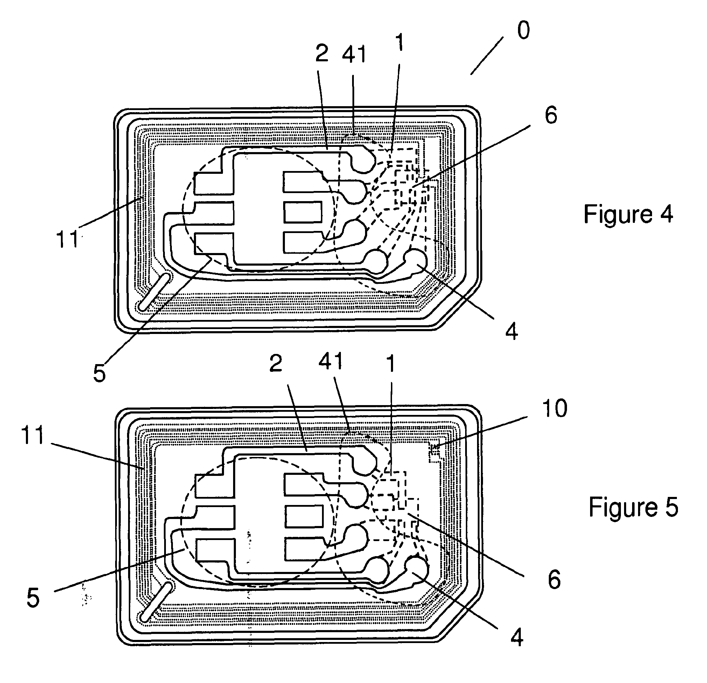

Selon une autre configuration (figure 5), la surface inférieure possède une plage de contact inférieure possédant des plots qui sont prolongés par des conducteurs (1) qui se dirigent chacun vers un trou (4) d'interconnexion différent ou identique d'une zone (41) d'interconnexion pour se connecter aux conducteurs (2) prolongeant les plots de la plage (5) de contact supérieure. Une autre plage de contact inférieure est connectée à une antenne RFID (11) apte à se connecter par communication par radiofréquence à un lecteur externe. L'antenne RFID (11) est, par exemple, située sur la surface inférieure du film (3) support. De façon non limitative, elle est composée d'une moins une spire située à proximité de la bordure du dispositif électronique à puce. Une puce (4) dédiée à la plage (5) de contact supérieure est fixée sur la plage de contact inférieure possédant des plots qui sont prolongés par des conducteurs (1) qui se dirigent chacun vers un trou (4) d'interconnexion différent ou identique pour se connecter aux conducteurs (2) prolongeant les plots de la plage (5) de contact supérieure. Une autre puce (10) dédiée à l'antenne RFID (11) est fixée sur la plage de contact inférieure connectée à l'antenne RFID (11). La zone (41) d'interconnexion est décalée par rapport à la plage (5) de contact supérieure ou la plage (7) de contact inférieure et par rapport à l'antenne RFID (11) ainsi qu'à l'extérieur du périmètre destiné à la ou aux puces.

Selon une autre configuration (figure 4), la surface inférieure possède une plage de contact inférieure possédant des plots qui sont prolongés par des conducteurs (1) qui se dirigent chacun vers un trou (4) d'interconnexion différent ou identique pour se connecter aux conducteurs (2) prolongeant les plots de la plage (5) de contact supérieure. Cette même plage de contact possède également des plots connectée à une antenne RFID (11) apte à se connecter par communication par radiofréquence à un lecteur externe. L'antenne RFID (11) est, par exemple, située sur la surface inférieure du film (3) support. De façon non limitative, elle est composée d'au moins une spire située à proximité de la bordure du dispositif électronique à puce. La plage (5) de contact supérieure et l'antenne RFID (11) communiquent avec une puce (4) disposée sur la plage de contact inférieure ainsi constituée. La puce (4) possède un dispositif d'interprétation qui détermine si la puce (4) est en configuration de communication avec la plage (5) de contact supérieure et/ou avec l'antenne RFID (11). Dans cette configuration, il est possible d'intégrer plusieurs antennes RFID (11) qui sont connectées chacune à une puce (4, 10) dédiée ou à une seule puce (4) possédant un dispositif d'interprétation qui détermine si la puce (4) est en configuration de communication avec la plage (5) de contact supérieure et/ou une des antennes RFID (11).

Il est connu qu'une puce (4) est un composant fragile. Le décalage de la ou des plages (7) de contact inférieures par rapport à la zone en vis-à-vis de la plage (5) de contact supérieure permet à la ou les puces (6) d'être protégées des efforts mécaniques qu'elles peuvent subir, ces efforts mécaniques pouvant provoquer la destruction de la ou des puces (6) lorsque les picots d'un lecteur extérieur s'appuie sur les plots de la plage (5) de contact supérieure.

La ou les puces (6) sont fixées sur leur plages (7) de contact inférieures dédiées par la technologie du la puce retournée (*Flip-Chip*)*.* Cette technique est une méthode pour interconnecter une puce à une plage de contact grâce à des billes de soudure qui sont disposées sur chaque plot d'une puce (4). Une colle ou un film anisotropique conducteur est préalablement déposée sur les plots de la plage de contact. Afin de monter la puce (4) sur les plots de la plage de contact, la puce (4) est retournée afin que les plots de contact de la puce (4) soient alignés de telle manière que ses plots de contact s'alignent avec les plots de contact correspondant de la plage de contact. Une soudure est alors effectuée, de façon non limitative, par compression, par séchage ou par thermo-compression pour compléter l'interconnexion.

Les plots de contact de la ou des puces (6) sont donc orientés vers la ou les plages de contact dédiées à la ou les puces (6) de la surface inférieure.

Les trous (4) d'interconnexion *(vias* en anglais) permettant de connecter la plage (5) de contact supérieure avec la ou les plages (7) de contact inférieures du film (3) support sont réalisés, de manière non limitative, mécaniquement par rivetage ou soudure ultrasonique ou par le remplissage d'un élément électriquement conducteur dans un trou.

De préférence les trous (4) d'interconnexion sont réalisés par une connexion de type sertissage ou *crimping* en anglais par emboutissage à l'aide d'une sonotrode. Cette technologie consiste à créer une connexion par enfoncement du film (3) support et de la couche métallisée de la surface enfoncée qui entre alors en contact avec la couche métallisée de la surface opposée à la surface enfoncée. Cette technologie donne la possibilité de ne pas avoir besoin de film plastique déjà embouti.

Le film (3) support est réalisé en matière de: préférence à bas coût et très fin. Il peut être en matière plastique transparente ou non transparente tel que le PVC (polychlorure de vinyle), le PC (polycarbonate), le PET (polyéthylène téréphtalate), le PETF (polyéthylène téréphtalate rendu cristallin par étirement), le PETG (polyéthylène téréphtalate glycolisé), le PP (polypropylène), le PS (polystyrène), le PPS (polysulfure de phénylène). Il peut être également en papier ou en matière végétale (bois, par exemple) pouvant être laminée et extrudée à des épaisseurs, par exemple, inférieure à 200 µm, de préférence inférieure à 150 µm. Le film (3) support peut aussi être une combinaison de tous ces matériaux. De façon non limitative, l'épaisseur du film (3) support est inférieure à 150 µm, de préférence 50 µm pour, par exemple, des raisons économiques.

De façon non limitative, les plages de contact et les conducteurs (1, 2) des faces supérieure et inférieure et/ou la ou les antennes RFID (11) peuvent être réalisés par gravure chimique d'une couche de matériau conducteur peu onéreux tel que l'aluminium ou le cuivre sur les deux surfaces d'un film (3) support. Cette couche de matériau conducteur peut avoir une épaisseur de 10 µm à 30 µm. Les plages de contact et les conducteurs (1, 2) des faces supérieure et inférieure et/ou les antennes RFID (11) peuvent être réalisés par impression ou métallisation ou sérigraphie d'une couche de matériau conducteur.

Le film (3) support a au moins deux côté parallèles ou adjacents de longueur égale aux côtés parallèles ou adjacents correspondant du dispositif électronique à puce.

Le film (9) épais, fixé sur la totalité ou sur au moins une partie de la surface du film (3) support du côté de la ou des puces, est constitué d'une ou plusieurs couches laminées en PVC (chlorure de polyvinyle), en ABS (acrylonitrile butadiène styrène), en PET (polyéthylène téréphtalate), en PETF (polyéthylène téréphtalate rendu cristallin par étirement), en PETG (polyéthylène téréphtalate glycolisé), en PP (polypropylène), en PS (polystyrène), en PPS (polysulfure de phénylène) ou toute autre matière autorisant un travail en bobine. La matière choisie donne la possibilité d'enrouler le film (9) épais en bobine. La matière peut également être en papier, en bois, en carton ou en plastique biodégradable ou bioplastique. De façon non limitative, le film (9) épais a une épaisseur égale à 0,7 mm. L'épaisseur est choisie selon les besoins. Par exemple, l'épaisseur peut être obtenue par le laminage de plusieurs couches de film (9) épais jusqu'à obtenir une épaisseur qui compense l'épaisseur de la ou des puces (6) fixées sur le film (3) support. L'épaisseur du film (9) épais ainsi obtenue peut donc être égale, supérieure ou inférieure à l'épaisseur de la ou des puces (6) fixées sur le film (3) support. Le film (9) épais peut permettre d'atteindre l'épaisseur finale désirée pour le dispositif (0) électronique à puce. Par exemple, l'épaisseur du dispositif (0) peut atteindre une épaisseur normalisée de 800 µm.

Le film (9) épais possède au moins une cavité (8) pouvant être un évidement ou un logement réalisée à le ou aux emplacements du ou des puces (6). La ou les cavités (8) possèdent des dimensions périphériques au moins égales à celles de la ou des puces (6). De préférence mais de façon non limitative, la largeur et la longueur de la ou des cavités (8) sont augmentées de 2 mm permettant ainsi avoir un espace de 1 mm entre le pourtour de la puce (4) et le rebord de la ou des cavités (8). De façon non limitative, le film épais est imprimé d'un élément sécuritaire ou cosmétique par gravure ou par impression sur au moins une de ses faces. L'élément ainsi imprimé sur le film (9) épais est alors visible sur le dispositif si le film (3) support ou toutes les couches additionnelles sont en matière transparente. Une violation de la ou des puces est alors apparente si une couche a été retirée pour atteindre la ou les puces.

De façon non limitative, une couche de protection ou esthétique est fixée sur le film (9) épais en vis-à-vis de la ou des puces (6). Cette couche de protection a pour but de protéger la puce (4) d'efforts mécaniques et/ou du rayonnement UV. Mais, elle peut également avoir pour but de sécuriser le dispositif électronique à puce par l'application d'un hologramme.

Un autre but est atteint en proposant un procédé de fabrication du dispositif électronique à puce selon l'invention.

Ce procédé a pour particularité de réduire le nombre d'étapes par rapport aux procédés de l'art antérieur. Ce procédé est entièrement réalisé à partir de bobines en utilisant des matériaux ou matières à faibles coûts et en optimisant les pertes de matières ou matériaux.

Ce procédé procure donc une économie substantielle en termes d'investissement en machines, en surface de bâtiment, en matériaux et en ressource humaine et énergétique pour son fonctionnement. Ce procédé permet une réduction de coût de 40 % environs par rapport à un procédé de l'art antérieur.

Le film (3) support est alimenté en continu par au moins une bobine fournissant une ou des bandes de largeur au moins égale à un multiple d'une des dimensions du dispositif électronique à puce. Sur les deux surfaces de la ou des bandes, une série de circuits conducteurs individuels pour une pluralité de dispositifs électronique à puce sont réalisés par impression ou métallisation ou sérigraphie d'une couche d'aluminium ou de cuivre.

Optionnellement, chaque circuit individuel d'un dispositif électronique à puce comportant les plages (5, 7) de contact, les conducteurs (1, 2) des faces supérieure et inférieure et/ou la ou les antennes RFID (11) constitué selon l'une des configurations exposées précédemment peut être repéré par un repère, par exemple, optique tel un trou ou un motif afin que les machines mettant en oeuvre le procédé de fabrication puisse repérer chaque circuit individuel pour, par exemple, fixer la ou les puces (6).

Le film (9) épais est alimenté en continu par au moins une bobine de même largeur que la bobine alimentant le film (3) support.

La bobine du film (3) support est déroulée pour réaliser les étapes suivantes en continu.

Dans une première étape, une pluralité de trous (4) d'interconnexion est réalisée en continu à travers le film (3) support dans la zone (41) d'interconnexion pour chaque circuit individuel par emboutissage.

Dans une étape suivante, une pluralité de connexion est réalisée en continu pour connecter les conducteur prolongeant la plage (5) de contact supérieure et les conducteur prolongeant la ou des plages (7) de contact inférieures par les trous (4) d'interconnexion. La connexion de la plage (5) de contact supérieure et de la ou des plages (7) de contact inférieures par les trous d'interconnexion consiste en une connexion par encrage mécanique ou rivetage, par soudure ultrasonique ou thermique ou par remplissage du trou d'interconnexion par un élément conducteur.

Dans une étape suivante, une colle liquide conductrice anisotropique ou un film de colle conductrice anisotropique est déposée en continu sur une pluralité de zones de ou des plages de contact inférieures de la bobine du film (3) support destinées à recevoir une puce (4).

Dans une étape suivante, une pluralité de puces (6) est fixée en continu sur la bande de la bobine du film (3) support sur les zones destinées à recevoir une puce (4).

Les puces (6) sont fixées par la technologie de la puce retournée (Flip-Chip) exposée précédemment. Avantageusement, un wafer entier comportant l'ensemble des puces (6) est préalablement retourné pour réaliser la fixation en puce retournée. La fixation se termine, par exemple, par un pressage à chaud qui permet une réticulation de la colle anisotropique conductrice ou toute autre action de fixation adaptée au matériau permettant la conduction électrique de la colle conductrice anisotropique ou du film de colle conductrice anisotropique.

Cette technologie de la puce retournée associée au retournement d'un wafer entier plutôt qu'un retournement de chaque puce permet facilement de fixer la ou les puces (6) sur la ou les plages (7) de contact inférieures qui sont décalées par rapport à la zone en vis-à-vis de la plage (5) de contact supérieure. De plus, le retournement d'un wafer entier permet d'éviter un retournement unitaire de chaque puce ce qui complexifierait le dispositif permettant la prise et la dépose des puces et ralentirait la cadence du procédé.

Optionnellement, l'étape de fixation sur la bande de la bobine du film (3) support d'une pluralité de puces (6) est suivie d'une étape de test et/ou de pré-personnalisation en continu des puces (6). Cette étape permet, par exemple, de repérer les puces (6) défectueuses qui seront mises au rebut pendant ou à la fin du procédé. Elle permet aussi, par exemple, de réaliser une personnalisation électrique préalable de la puce en chargeant un système d'exploitation (*operating system* en anglais) ou des données fixes dans la puce. Les données variables peuvent être chargées ultérieurement.

Dans une étape suivante, la bande du film (3) support avec les puces (6) fixées est mise en bobine(s) en continu.

Dans une étape suivante, la bobine du film (3) support avec les puces (6) fixées est reportée sur un dispositif permettant de réaliser la suite du procédé.

La bobine du film (9) épais et la bobine du film (3) support avec les puces (6) fixées sont déroulées pour réaliser les étapes suivantes en continu.

Une étape d'emboutissage ou de découpe est alors réalisée en continu sur la bande du film (9) épais pour obtenir des cavités (8) réalisés aux emplacements des puces (6).

L'étape d'emboutissage ou de découpe de la bande de la bobine du film (9) épais est précédée ou suivie d'une étape de dépôt en continu d'un film adhésif ou d'une préparation de surface permettant un thermoformage par laminage sur la surface de la bande de la bobine du film (9) épais destinée à être fixée sur la bande de la bobine du film (3) support.

Optionnellement, l'étape d'emboutissage ou de découpe de la bande de la bobine du film (9) épais et/ou l'étape de dépôt d'un film adhésif sur la surface de la bande de la bobine du film (9) épais sont précédées d'une étape de dépôt en continu d'une protection sur les surfaces de la bande de la bobine du film (9) épais.

Optionnellement, l'étape d'emboutissage ou de découpe de la bande de la bobine du film (9) épais et/ou l'étape de dépôt d'un film adhésif sur la surface de la bande de la bobine du film (9) épais et/ou l'étape de dépôt d'une protection sont précédées d'une étape de pré-personnalisation en continu sur au moins une des surfaces de la bande de la bobine du film (9) épais par impression ou par gravure. L'impression peut être réalisée par imprimante à jet d'encre. La gravure peut être réalisée par laser.

Optionnellement, l'étape de dépôt d'un film adhésif peut être réalisée sur la surface inférieure de la bande de la bobine du film (3) support. Dans cette option, cette étape de dépôt d'un film adhésif suit ou précède l'étape de réalisation d'une pluralité de trous d'interconnexion à travers la bande de la bobine du film (3) support.

Optionnellement, l'étape d'emboutissage ou de découpe de la bande de la bobine du film (9) épais est suivie d'une étape d'impression en continu d'un élément sécuritaire ou cosmétique par gravure ou par impression sur au moins une des surfaces de la bande de la bobine du film (9) épais. L'élément sécuritaire peut être un numéro de série ou un motif ou tout autre élément permettant d'éviter une utilisation frauduleuse du dispositif électronique à puce.

Dans une étape suivante, les bandes du film (9) et du film (3) support sont amenées en superposition. La bande de la bobine du film (9) épais est alors fixée en continu sur la bande de la bobine du film (3) support avec les puces (6) fixées. Les cavités réalisées aux emplacements des puces (6) entrent en coïncidence avec les puces (6) fixées sur le film (3) support.

La fixation de la bande de la bobine du film (9) épais sur la bande de la bobine du film (3) support peut être réalisée par collage, par adhésion ou par thermoformage par laminage en continu.

Dans une étape (208) suivante ou précédente, une couche de protection mécanique et/ou optique ou esthétique est fixée en continu par collage ou thermoformage sur le film (9) épais en vis-à-vis de la ou des puces (6) sur la cavité (8) de la ou des puces (6). Cette couche de protection est alimentée en continu par une bobine.

Cette couche de protection, comme expliqué précédemment, a pour but de protéger la puce (4) d'efforts mécaniques et/ou du rayonnement UV. Mais, elle peut également avoir pour but de sécuriser le dispositif électronique à puce par l'application d'un hologramme.

Optionnellement, l'étape de dépôt d'une protection mécanique et/ou optique de la pluralité de puces (6) est suivie d'une étape de personnalisation en continu du dispositif électronique à puce par gravure laser ou mécanique ou par impression ou par transfert thermique.

L'étape de dépôt d'une protection mécanique et/ou optique de la pluralité de puces (6) peut être éventuellement suivie d'une étape de personnalisation électrique de la ou des puces (6) à l'aide d'une carte à picots ou d'un dispositif à antenne sans contact connecté à un lecteur encodeur externe.

Dans une étape suivant l'étape de personnalisation électrique de la ou des puces (6) à l'aide d'une carte à picots ou d'un dispositif à antenne sans contact connecté à un lecteur encodeur externe une étape du personnalisation du dispositif électronique à puce par gravure ou par impression ou par transfert thermique sur la face de la bande de la bobine du film (9) épais qui n'est pas fixée de la bande de la bobine du film (3) support peut être éventuellement réalisée.

De même, dans une autre étape suivant l'étape de personnalisation électrique de la ou des puces (6) à l'aide d'une carte à picots connecté à un lecteur externe, une étape de personnalisation du dispositif électronique à puce par gravure ou par impression ou par transfert thermique sur la face inférieure de la bande de la bobine du film (3) support qui n'est pas fixée sur le film (3) support peut être réalisée.

Dans une configuration du procédé, l'étape de personnalisation du dispositif électronique à puce par gravure ou par impression ou par transfert thermique sur la face inférieure de la bande de la bobine du film (3) support peut être réalisée à n'importe quel moment après l'étape de fixation sur la bande de la bobine du film (3) support de la ou des puces (6).

L'étape de personnalisation du dispositif électronique à puce par gravure ou par impression ou par transfert thermique sur la face inférieure de la bande de la bobine du film (3) support peut être suivie d'une étape de personnalisation du dispositif électronique à puce par gravure ou par impression ou par transfert thermique sur la face de la bande de la bobine du film (9) épais qui n'est pas fixée à la bande de la bobine du film (3) support.

Dans une étape suivant l'étape de dépôt d'une protection mécanique et/ou optique de la pluralité de puces (6) est suivie d'une mise en bobine en continu de la bande de la bobine du film (3) support et de la bande de la bobine du film (9) épais assemblés selon les étapes précédentes est réalisée.

Selon une autre option, l'étape de dépôt d'une protection mécanique et/ou optique de la pluralité de puces (6) peut être aussi suivie d'une étape de découpe de la bande de la bobine du film (3) support et de la bande de la bobine du film (9) épais assemblés selon les étapes précédentes en dispositifs électronique à puce individuels.

L'étape de découpe peut être suivie d'une étape de conditionnement des dispositifs électronique à puce découpés. Le conditionnement peut être un conditionnement en bobines avec des prédécoupes permettant le détachement facile de chaque dispositif électronique à puce, en clayettes ou en tube.

Selon une configuration du procédé, dans une étape suivant les étapes de personnalisation du dispositif électronique à puce par gravure ou par impression ou par transfert thermique, une étape de fixation d'un film transparent peut être réalisée. Ce film transparent permet de protéger la personnalisation graphique et de sécurisation du dispositif électronique à puce. L'enlèvement de cette couche démontre une contrefaçon du dispositif électronique à puce.

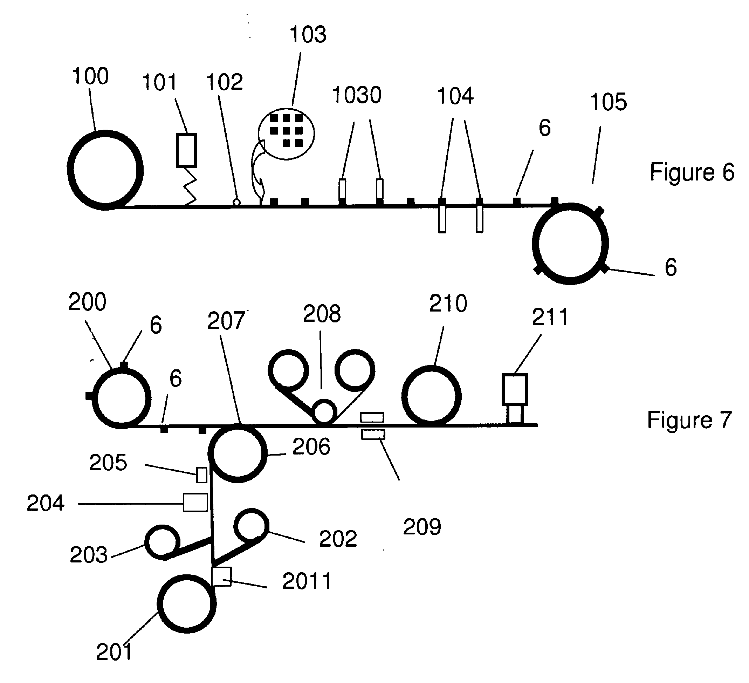

Un autre but est atteint en proposant une machine mettant en oeuvre le procédé de fabrication du dispositif électronique à puce selon l'invention en référence aux figures 6 et 7.

La machine comportant au moins les dispositifs suivants :
- un dispositif (100) de débobinage d'une bande de film (3) support pourvu de pistes conductrices sur les deux faces ;
- un dispositif (101) d'emboutissage mécanique ou ultrasonique de trous d'interconnexion;
- un dispositif (102) de dépôt de colle ou de film adhésif sur une pluralité de zones de ou des plages de contacts inférieures destinées à recevoir une puce;
- un dispositif (103) de dépôt de puce(s) ;
- un dispositif (1030) de pressage et réticulation de la colle ou d'activation du film adhésif ;
- un dispositif (105) d'enroulement en bobine de la bande du film avec les puces de telle façon que les puces soient à l'extérieures.
- un dispositif (204) d'emboutissage disposé en vis-à-vis de la face de la bande du film épais qui est la face de jonction avec le film support ;
- un dispositif (207) de liaison des deux films épais et support,

Le dispositif (102) de dépôt de colle ou de produit adhésif peut être un dispositif de dépôt de tout moyen de fixation et de contact électrique d'une puce.

Le dispositif (1030) de pressage et réticulation de la colle ou d'activation de l'adhésif peut être un dispositif permettant l'activation de tout moyen de fixation et de contact électrique d'une puce.

Selon une autre particularité, la machine est composée en outre d' :
- un dispositif (200) de déroulement d'une bande de film support avec puces ;
- un dispositif (201) de déroulement d'un film épais ;
- un dispositif (203) de dépôt d'un adhésif ;
- un dispositif (205) de dépôt d'un élément sécuritaire ou cosmétique ;
- un dispositif (208) de dépôt par laminage de protection mécanique et/ou optique des puces ;
- un dispositif (211) de découpe en dispositifs électroniques à puce individuels.

Optionnellement, la machine est composée en outre d'un dispositif de test et de pré-personnalisation des puces.

Optionnellement, la machine est composée en outre d'un dispositif (2011) de pré-personnalisation graphique sur au moins une des faces du film épais.

Optionnellement, la machine est composée en outre d'un dispositif (202) de dépôt d'une couche de protection par laminage.

Optionnellement, la machine est composée en outre d'un dispositif (209) de personnalisation sur la face du film épais qui est la face opposée à la face de jonction avec le film support et/ou sur la face du film support qui est la face opposée à la face de jonction avec le film épais.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la portée des revendications jointes, et l'invention ne doit pas être limitée aux détails donnés ci-dessus.

## Revendications

1. Dispositif (0) électronique à puce comportant au moins :
- un module électronique comportant au moins :
- un film (3) support souple, dont les dimensions correspondent à une des dimensions du dispositif électronique dont la surface supérieure possède une plage (5) de contact supérieure et dont la surface inférieure possède au moins une plage (7) de contact inférieure, chaque plage de contact étant prolongée par des conducteurs (1, 2) reliés par interconnexion (4) à travers le film (3) support dans une zone (41) d'interconnexion de telle façon qu'au moins une plage (7) de contact inférieure est reliée à la plage (5) de contact supérieure, la ou les plages (7) de contact inférieures intersectant le périmètre destiné à être occupé par au moins une puce (6, 10) reliée selon la technologie de la puce retournée à chaque plage (7) de contact inférieure et la ou les plages (7) de contact inférieures étant décalées par rapport à la zone du film (3) support en vis-à-vis de la zone dont le périmètre encercle la plage (5) de contact supérieure ; la ou les plages (5, 7) de contact de la surface inférieure et supérieure et les conducteurs (1, 2) étant en matériau conducteur sans composant onéreux tel que le nickel ou l'or;
- un film (9) épais, pourvu d'au moins une cavité (8) en vis-à-vis de la zone où la puce du film (3) support vient en vis-à-vis, et fixé sur au moins une partie de la surface du film (3) support du côté de la puces.

2. Dispositif (0) selon la revendication 1, **caractérisé en ce que** le dispositif (0) électronique à puce est une carte à puce dont la plage (5) de contact supérieure est un bomier agencé selon la norme ISO 7816 avec des plages (5) de contact en aluminium, en argent ou en cuivre pour se connecter à un lecteur externe.

3. Dispositif (0) selon la revendication 1, **caractérisé en ce que** le dispositif (0) électronique à puce est un objet intelligent dont la plage (5) de contact supérieure est un bomier agencé selon la norme adaptée à l'objet intelligent.

4. Dispositif (0) selon la revendication 1, **caractérisé en ce que** le dispositif (0) électronique à puce comporte en outre une antenne (11) RFID apte à se connecter par communication par radiofréquence à un lecteur externe, l'antenne (11) RFID étant située sur la surface inférieure du film (3) support.

5. Dispositif (0) selon la revendication 4, **caractérisé en ce que** la plage (5) de contact supérieure communique avec une puce (6) dédiée au bomier, l'antenne (11) RFID communiquant avec une puce (10) spécifique à l'antenne (11) RFID.

6. Dispositif (0) selon la revendication 4, **caractérisé en ce que** la plage (5) de contact supérieure et l'antenne (11) RFID communiquent avec une puce (6) possédant un dispositif d'interprétation qui détermine si la puce (6) est en configuration de communication avec la plage (5) de contact supérieure ou avec l'antenne (11) RFID.

7. Dispositif (0) selon au moins une des revendications précédentes, **caractérisé en ce que** les plots de contact de la ou des puces (6, 10) sont orientés vers la ou les plages (7) de contact dédiées à la ou les puces (6, 10) de la surface inférieure du film (3) support.

8. Dispositif (0) selon au moins une des revendications précédentes, **caractérisé en ce que** le film (3) support est en matière plastique PVC, PC, PET, PETF, PETG, PP, PS, PPS, en papier ou en matière végétale pouvant être laminée et extrudée à des épaisseurs sensiblement égales à 150 µm ou une combinaison de ces matières, l'épaisseur du film (3) étant préférentiellement sensiblement égale à 50 µm.

9. Dispositif (0) selon au moins une des revendications précédentes, **caractérisé en ce que** le film (9) épais est constitué d'une ou plusieurs couches en PVC, en ABS, en PET, PETF, PETG, PP, PS, PPS ou tout autre matière autorisant un travail en bobine, ou en bois, ou en carton ou en bioplastique.

10. Dispositif (0) selon au moins une des revendications précédentes, **caractérisé en ce que** les plages (5, 7) de contact et les conducteurs (1, 2) des surfaces supérieure et inférieure du film (3) support sont en aluminium ou en cuivre.

11. Dispositif (0) selon au moins une des revendications précédentes, **caractérisé en ce que** le film (3) support a au moins deux côté parallèles ou adjacents de longueur égale aux côtés parallèles ou adjacents du dispositif (0) électronique à puce.

12. Dispositif (0) selon la revendication 1, **caractérisé en ce que** la zone (41) d'interconnexion est décalée par rapport à la plage (5) de contact supérieure ou la plage (7) de contact inférieure et à l'extérieur du périmètre destiné à la ou aux puces.

13. Dispositif (0) selon la revendication 1 et 4, **caractérisé en ce que** la zone (41) d'interconnexion est décalée par rapport à la plage (5) de contact supérieure ou la plage (7) de contact inférieure et par rapport à l'antenne RFID (11) ainsi qu'à l'extérieur du périmètre destiné à la ou aux puces.

14. Procédé de fabrication du dispositif (0) électronique à puce selon les revendications 1 à 13, **caractérisé en ce que** un film (3) support est alimenté en continu par au moins une bobine fournissant une bande de largeur au moins égale à un multiple d'une des dimensions du dispositif (0) électronique à puce, les deux surfaces de la bande de la bobine de film (3) support comportant une série de circuits conducteurs individuels pour une pluralité de dispositifs (0) électronique à puce, chaque circuit individuel étant réalisé de telle façon que la surface supérieure possède une première plage (5) de contact et que la surface inférieure possède au moins une deuxième plage (7) de contact, chaque plage de contact étant prolongée par des conducteurs (1, 2) vers une zone (41) d'interconnexion de telle façon qu'au moins une plage (7) de contact inférieure est reliée à la plage (5) de contact supérieure, la ou les plages (7) de contact inférieures intersectant le périmètre destiné à être occupé par les contacts d'une puce (6, 10) reliée électriquement à chaque plage (7) de contact inférieure et la ou les plages (7) de contact inférieures étant décalées par rapport à la zone du film (3) support en vis-à-vis de la zone dont le périmètre encercle la plage (5) de contact supérieure, et **en ce qu'**il comporte au moins les étapes suivantes :
- une étape de réalisation dans la zone (41) d'interconnexion d'une pluralité de trous (4) d'interconnexion à travers le film (3) support ;
- une étape de connexion de la plage (5) de contact supérieure et de la ou des plages (7) de contact inférieures par les trous (4) d'interconnexion ;
- une étape de dépôt d'une colle conductrice anisotropique sur une pluralité de zones de ou des plages (7) de contact inférieures de la bande de la bobine du film (3) support destinées à recevoir une puce ;
- une étape de fixation sur la bande de la bobine du film (3) support d'au moins une puce sur la ou les zones destinées à recevoir une puce ;
- une étape de mise en bobine(s) de la bande du film (3) support avec les puces fixées ;
- une étape d'emboutissage ou de découpe d'une bande du film (9) épais de même largeur que la bande ou une des dimensions du dispositif (0) électronique pour obtenir une ou des cavités (8) réalisées aux emplacements des puces (6, 10);
- une étape d'amenée en superposition des deux bandes et d'adhésion ou de collage de la bande de la bobine du film (9) épais sur la bande de la bobine du film (3) support avec les puces (6, 10) fixées.

15. Procédé selon la revendication 14, **caractérisé en ce que** l'étape d'adhésion ou de collage de la bande de la bobine du film (9) épais sur la bande de la bobine du film (3) support avec les puces fixées est suivie ou précédée d'une étape de dépôt d'une protection mécanique et/ou optique de la puce (6, 10).

16. Procédé selon la revendication 14, **caractérisé en ce que** l'étape de connexion de la plage (5) de contact supérieure et de la ou des plages (7) de contact inférieures par les trous (4) d'interconnexion consiste en une connexion par encrage mécanique ou rivetage, par soudure ultrasonique ou thermique ou par remplissage du trou (4) d'interconnexion par un élément conducteur.

17. Procédé selon la revendication 14, **caractérisé en ce que** l'étape de fixation sur la bande de la bobine du film (3) support de la ou des puces (6, 10) consiste en une fixation de la ou des puces (6, 10) par la technologie de la puce retournée.

18. Procédé selon une des revendications précédentes, **caractérisé en ce que** l'étape de fixation sur la bande de la bobine du film (3) support d'une pluralité de puces (6, 10) est suivie d'une étape de test et/ou de pré-personnalisation des puces (6, 10).

19. Procédé selon la revendication 14, **caractérisé en ce que** l'étape de réalisation d'une pluralité de trous (4) d'interconnexion à travers la bande de la bobine du film (3) support est précédée d'une étape de dépôt d'un film adhésif sur toute la surface inférieure de la bande de la bobine du film (3) support.

20. Procédé selon la revendication 14, **caractérisé en ce que** l'étape d'emboutissage ou de découpe de la bande de la bobine du film (9) épais est précédée ou suivie d'une étape de dépôt d'un film adhésif sur la surface de la bande de la bobine du film (9) épais destinée à être fixée sur la bande de la bobine du film (3) support.

21. Procédé selon la revendication 14 et 20, **caractérisé en ce que** l'étape d'emboutissage ou de découpe de la bande de la bobine du film (9) épais et/ou l'étape de dépôt d'un film adhésif sur la surface de la bande de la bobine du film (9) épais sont précédées d'une étape de dépôt d'une protection sur les surfaces de la bande de la bobine du film (9) épais.

22. Procédé selon la revendication 14, 20 et 21, **caractérisé en ce que** l'étape d'emboutissage ou de découpe de la bande de la bobine du film (9) épais et/ou l'étape de dépôt d'un film adhésif sur la surface de la bande de la bobine du film (9) épais et/ou l'étape de dépôt d'une protection sont précédées d'une étape de pré-personnalisation sur au moins une des surfaces de la bande de la bobine du film (9) épais par impression ou par gravure.

23. Procédé selon la revendication 14, **caractérisé en ce que** l'étape d'emboutissage ou de découpe de la bande de la bobine du film (9) épais est suivie d'une étape d'impression d'un élément sécuritaire ou cosmétique par gravure ou par impression sur au moins une des surfaces de la bande de la bobine du film (9) épais, l'élément sécuritaire ou cosmétique étant visible sur le dispositif (0) électronique à puce si le film (3) support est en matière transparente.

24. Procédé selon la revendication 15, **caractérisé en ce que** l'étape de dépôt d'une protection mécanique et/ou optique de la pluralité de puces est éventuellement suivie d'une étape de personnalisation électrique de la ou des puces à l'aide d'une carte à picots ou d'un dispositif à antenne sans contact connectés à un lecteur encodeur externe.

25. Procédé selon la revendication 24, **caractérisé en ce que** l'étape de personnalisation électrique de la ou des puces (6, 10) à l'aide d'une carte à picots connecté à un lecteur externe est éventuellement suivie d'une étape du personnalisation du dispositif électronique à puce(s) par gravure ou par impression ou par transfert thermique sur la face de la bande de la bobine du film (9) épais qui n'est pas fixée de la bande de la bobine du film (3) support.

26. Procédé selon la revendication 15, **caractérisé en ce que** l'étape de dépôt d'une protection mécanique et/ou optique de la pluralité de puces (6, 10) est suivie d'une étape de personnalisation du dispositif électronique à puce(s) par gravure ou par impression ou par transfert thermique sur la face inférieure de la bande de la bobine du film (3) support qui n'est pas fixée sur le film (3) support.

27. Procédé selon les revendication 17 et 26, **caractérisé en ce que** l'étape de personnalisation du dispositif (0) électronique à puce(s) par gravure ou par impression ou par transfert thermique sur la face inférieure de la bande de la bobine du film (3) support est réalisée à n'importe quel moment après l'étape de fixation sur la bande de la bobine du film (3) support de la ou des puces.

28. Procédé selon les revendications 26 et 27, **caractérisé en ce que** l'étape de personnalisation du dispositif électronique à puce(s) par gravure ou par impression ou par transfert thermique sur la face inférieure de la bande de la bobine du film (3) support est suivie d'une étape de personnalisation du dispositif électronique à puce(s) par gravure ou par impression ou par transfert thermique sur la face de la bande de la bobine du film (9) épais qui n'est pas fixée de la bande de la bobine du film (3) support.

29. Procédé selon la revendication 14, **caractérisé en ce que** l'étape de dépôt d'une protection mécanique et/ou optique de la pluralité de puces est suivie d'une étape de mise en bobine de la bande de la bobine du film (3) support et de la bande de la bobine du film (9) épais assemblés selon les étapes précédentes.

30. Procédé selon la revendication 15, **caractérisé en ce que** l'étape de dépôt d'une protection mécanique et/ou optique de la pluralité de puces (6, 10) est suivie d'une étape de découpe de la bande de la bobine du film (3) support et de la bande de la bobine du film (9) épais assemblés selon les étapes précédentes en dispositifs électronique à puce(s) individuels.

31. Procédé selon la revendication 30, **caractérisé en ce que** l'étape de découpe est suivie d'une étape de conditionnement des dispositifs électronique à puce(s) découpés.

32. Machine permettant la mise en oeuvre du procédé selon les revendications 14 à 31 de fabrication du dispositif (0) électronique à puce selon les revendications 1 à 13, **caractérisée en ce qu'**elle comporte au moins les dispositifs suivants :
- un dispositif (100) de débobinage d'une bande de film (3) support pourvu de pistes conductrices sur les deux faces ;
- un dispositif (101) d'emboutissage mécanique ou ultrasonique de trous d'interconnexion ;
- un dispositif (102) de dépôt de colle ou de film adhésif sur une pluralité de zones de ou des plages de contacts inférieures destinées à recevoir une puce (4) ;
- un dispositif (103) de dépôt de puce(s) ;
- un dispositif (1030) de pressage et réticulation de la colle ou d'activation du film adhésif ;
- un dispositif (105) d'enroulement en bobine de la bande du film avec les puces de telle façon que les puces soient à l'extérieures ;
- un dispositif (204) d'emboutissage disposé en vis-à-vis de la face de la bande du film (9) épais qui est la face de jonction avec le film (3) support :
- un dispositif (207) de liaison des deux films épais et support.

33. Machine selon la revendication 32, **caractérisée en ce qu'**elle est composée en outre d' :
- un dispositif (200) de déroulement d'une bande de film (3) support avec puces ;
- un dispositif (201) de déroulement d'un film (9) épais ;
- un dispositif (205) de dépôt d'un élément sécuritaire ou cosmétique ;
- un dispositif (208) de dépôt par laminage de protection mécanique et/ou optique des puces ;
- un dispositif (211) de découpe en dispositifs électroniques à puce individuels.

34. Machine selon les revendications 32 et 33, **caractérisée en ce qu'**elle est composée en outre d'un dispositif de dépôt d'un adhésif ou d'une préparation de surface.

35. Machine selon les revendications 32 et 34, **caractérisée en ce qu'**elle est composée en outre d'un dispositif de test et de pré-personnalisation des puces.

36. Machine selon les revendications 32 à 35, **caractérisée en ce qu'**elle est composée en outre d'un dispositif (2011) de pré-personnalisation graphique sur au moins une des faces du film (9) épais.

37. Machine selon les revendications 32 à 36, **caractérisée en ce qu'**elle est composée en outre d'un dispositif (202) de dépôt d'une couche de protection par laminage.

38. Machine selon les revendications 32 à 37, **caractérisée en ce qu'**elle est composée en outre d'un dispositif (209) de personnalisation sur la face du film (9) épais qui est la face opposée à la face de jonction avec le film (3) support et/ou sur la face du film (3) support qui est la face opposée à la face de jonction avec le film (9) épais.

## Patentansprüche

1. Elektronische Chip-Vorrichtung (0), die mindestens Folgendes umfasst:
- eine Elektronik-Baugruppe, die mindestens Folgendes umfasst:
- eine biegsame dünne Trägerschicht (3), deren Abmessungen einer der Abmessungen der elektronischen Vorrichtung entsprechen, deren obere Fläche einen oberen Kontaktbereich (5) aufweist und deren untere Fläche mindestens einen unteren Kontaktbereich (7) aufweist, wobei jeder Kontaktbereich durch Leiter (1, 2) verlängert ist, die derart durch Verbindung (4) durch die dünne Trägerschicht (3) in einer Verbindungszone (41) verbunden sind, dass mindestens ein unterer Kontaktbereich (7) mit dem oberen Kontaktbereich (5) verbunden ist, wobei der oder die untere/n Kontaktbereich/e (7) den Umfang schneidet/schneiden, der dazu bestimmt ist, durch mindestens einen Chip (6, 10) eingenommen zu werden, der gemäß der Flipchip-Technologie mit jedem unteren Kontaktbereich (7) verbunden ist, und der oder die unteren Kontaktbereich/e (7) in Bezug zur Zone der dünnen Trägerschicht (3) gegenüber der Zone, deren Umfang den oberen Kontaktbereich (5) einkreist, versetzt sind; wobei der oder die Kontaktbereich/e (5, 7) der unteren und oberen Fläche und die Leiter (1, 2) aus leitendem Material ohne teuren Bestandteil, wie beispielsweise Nickel oder Gold, besteht/bestehen;
- eine Dickschicht (9), die mit mindestens einem Hohlraum (8) gegenüber der Zone versehen ist, in der der Chip der dünnen Trägerschicht (3) mindestens auf einem Teil der Fläche der dünnen Trägerschicht (3) auf der Seite des Chips gegenüberliegend angeordnet und darauf befestigt wird.

2. Vorrichtung (0) nach Anspruch 1, **dadurch gekennzeichnet, dass** die elektronische Chip-Vorrichtung (0) eine Chipkarte ist, deren oberer Kontaktbereich (5) eine Klemmleiste ist, die gemäß der Norm ISO 7816 mit Kontaktbereichen (5) aus Aluminium, aus Silber oder aus Kupfer angeordnet ist, um an einen externen Leser angeschlossen zu werden.

3. Vorrichtung (0) nach Anspruch 1, **dadurch gekennzeichnet, dass** die elektronische Chipvorrichtung (0) ein intelligentes Objekt ist, dessen oberer Kontaktbereich (5) eine Klemmleiste ist, die gemäß der Norm angeordnet ist, die an das intelligente Objekt angepasst ist.

4. Vorrichtung (0) nach Anspruch 1, **dadurch gekennzeichnet, dass** die elektronische Chipvorrichtung (0) ferner eine RFID-Antenne (11) umfasst, die geeignet ist, sich durch Hochfrequenz-Kommunikation mit einem externen Leser zu verbinden, wobei die RFID-Antenne (11) sich auf der unteren Fläche der dünnen Trägerschicht (3) befindet.

5. Vorrichtung (0) nach Anspruch 4, **dadurch gekennzeichnet, dass** der obere Kontaktbereich (5) mit einem dedizierten Chip (6) der Klemmleiste in Verbindung steht, wobei die RFID-Antenne (11) mit einem spezifischen Chip (10) der RFID-Antenne (11) in Verbindung steht.

6. Vorrichtung (0) nach Anspruch 4, **dadurch gekennzeichnet, dass** der obere Kontaktbereich (5) und die RFID-Antenne (1) mit einem Chip (6) in Verbindung stehen, der eine Auswertungsvorrichtung aufweist, die bestimmt, ob der Chip (6) sich in der Ausgestaltung zur Verbindung mit dem oberen Kontaktbereich (5) oder mit der RFID-Antenne (11) befindet.

7. Vorrichtung (0) nach einem der vorhergehenden Ansprüche, **dadurch gekennzeichnet, dass** die Kontaktstücke des oder der Chips (6, 10) in Richtung des oder der dedizierten Kontaktbereiche (7) des oder der Chips (6, 10) der unteren dünnen Trägerschicht (3) ausgerichtet sind.

8. Vorrichtung (0) nach einem der vorhergehenden Ansprüche, **dadurch gekennzeichnet, dass** die dünne Trägerschicht (3) aus PVC-, PC-, PET-, PETF-, PETG-, PP-, PS-, PPS-Kunststoff, aus Papier oder aus einem pflanzlichen Stoff, der auf Dicken von im Wesentlichen gleich 150 µm gewalzt und extrudiert werden kann, oder einer Kombination dieser Stoffe besteht, wobei die Dicke der dünnen Schicht (3) vorzugsweise im Wesentlichen gleich 50 µm ist.

9. Vorrichtung (0) nach einem der vorhergehenden Ansprüche, **dadurch gekennzeichnet, dass** die Dickschicht (9) aus einer oder mehreren Schichten aus PVC, aus ABS, aus PET, PETF, PETG, PP, PS, PPS oder irgendeinem anderen Material, das eine Arbeit als Spule zulässt, oder aus Holz, oder aus Pappe oder aus Biokunststoff gebildet ist.

10. Vorrichtung (0) nach einem der vorhergehenden Ansprüche, **dadurch gekennzeichnet, dass** die Kontaktbereiche (5, 7) und die Leiter (1, 2) der oberen und der unteren Fläche der dünnen Trägerschicht (3) aus Aluminium oder aus Kupfer sind.

11. Vorrichtung (0) nach einem der vorhergehenden Ansprüche, **dadurch gekennzeichnet, dass** die dünne Trägerschicht (3) mindestens zwei parallele oder benachbarte Seiten aufweist, deren Länge gleich derjenigen der parallelen oder benachbarten Seiten der elektronischen Chip-Vorrichtung (0) ist.

12. Vorrichtung (0) nach Anspruch 1, **dadurch gekennzeichnet, dass** die Verbindungszone (41) in Bezug zum oberen Kontaktbereich (5) oder zum unteren Kontaktbereich (7) und zur Außenseite des für den oder die Chips bestimmten Umfangs versetzt ist.

13. Vorrichtung (0) nach Anspruch 1 und 4, **dadurch gekennzeichnet, dass** die Verbindungszone (41) in Bezug zum oberen Kontaktbereich (5) oder zum unteren Kontaktbereich (7) und in Bezug zur RFID-Antenne (11) sowie zur Außenseite des für den oder die Chips bestimmten Umfangs versetzt ist.

14. Verfahren zur Herstellung der elektronischen Chip-Vorrichtung (0) nach Anspruch 1 bis 13, **dadurch gekennzeichnet, dass** eine dünne Trägerschicht (3) ununterbrochen durch mindestens eine Spule mit Strom versorgt wird, die einen Streifen mit einer Breite liefert, die mindestens gleich einem Vielfachen von einer der Abmessungen der elektronischen Chipvorrichtung (0) ist, wobei die zwei Flächen des Bandes der Spule der dünnen Trägerschicht (3) eine Reihe einzelner leitender Schaltungen für mehrere elektronische Chip-Vorrichtungen (0) tragen, wobei jede einzelne Schaltung derart ausgeführt ist, dass die obere Fläche einen ersten Kontaktbereich (5) aufweist und dass die untere Fläche mindestens einen zweiten Kontaktbereich (7) aufweist, wobei jeder Kontaktbereich durch Leiter (1, 2) derart in Richtung einer Verbindungszone (41) verlängert wird, dass mindestens ein unterer Kontaktbereich (7) mit dem oberen Kontaktbereich (5) verbunden ist, wobei der oder die unteren Kontaktbereiche (7) den Umfang schneiden, der dazu bestimmt ist, durch die Kontakte eines Chips (6, 10) eingenommen zu werden, der elektrisch mit jedem unteren Kontaktbereich (7) verbunden ist, und der oder die untere/n Kontaktbereich/e (7) in Bezug zur Zone der dünnen Trägerschicht (3) gegenüber der Zone versetzt ist/sind, deren Umfang den oberen Kontaktbereich (5) einkreist, und dadurch, dass es mindestens die folgenden Schritte umfasst:
- einen Schritt des Ausführens mehrerer Verbindungslöcher (4) durch die dünne Trägerschicht (3) in der Verbindungszone (41);
- einen Schritt des Verbindens des oberen Kontaktbereichs (5) und des oder der unteren Kontaktbereiche (7) durch Verbindungslöcher (4);
- einen Schritt des Auftragens eines anisotropen leitfähigen Klebers auf mehreren Zonen des oder der unteren Kontaktbereiche (7) des Streifens der Spule der dünnen Trägerschicht (3), die dazu bestimmt sind, einen Chip aufzunehmen;
- einen Schritt des Befestigens von mindestens einem Chip auf dem Streifen der Spule der dünnen Trägerschicht (3) auf der oder den Zonen, die dazu bestimmt sind, einen Chip aufzunehmen;
- einen Schritt des Aufspulens des Streifens der dünnen Trägerschicht (3) mit den befestigten Chips;
- einen Schritt des Tiefziehens oder des Schneidens eines Streifens der Dickschicht (9) mit derselben Breite wie der Streifen oder eine der Abmessungen der elektronischen Vorrichtung (0) zum Erhalten von einem oder mehreren Hohlräumen (8), die an den Stellen der Chips (6, 10) ausgeführt sind;
- einen Schritt des Übereinanderschichtens der zwei Streifen und des Zumhaftenbringens oder des Klebens des Streifens der Spule der Dickschicht (9) auf dem Streifen der Spule der dünnen Trägerschicht (3) mit den befestigten Chips (6, 10).

15. Verfahren nach Anspruch 14, **dadurch gekennzeichnet, dass** dem Schritt des Zumhaftenbringens oder des Klebens des Streifens der Spule der Dickschicht (9) auf dem Streifen der Spule der dünnen Trägerschicht (3) mit den befestigten Chips ein Schritt des Auftragens eines mechanischen und/oder optischen Schutzes des Chips (6, 10) folgt oder vorausgeht.

16. Verfahren nach Anspruch 14, **dadurch gekennzeichnet, dass** der Schritt des Verbindens des oberen Kontaktbereichs (5) und des oder der unteren Kontaktbereiche (7) durch Verbindungslöcher (4) aus einer Verbindung durch mechanische Verankerung oder Nieten, durch Ultraschallschweißen oder thermisches Schweißen oder durch Füllen des Verbindungslochs (4) mit einem leitfähigen Element besteht.

17. Verfahren nach Anspruch 14, **dadurch gekennzeichnet, dass** der Schritt des Befestigens des oder der Chips (6, 10) auf dem Streifen der Spule der dünnen Trägerschicht (3) aus einer Befestigung des oder der Chips (6, 10) durch die Flipchip-Technologie besteht.

18. Verfahren nach einem der vorhergehenden Ansprüche, **dadurch gekennzeichnet, dass** auf den Schritt des Befestigens mehrerer Chips (6, 10) auf dem Streifen der Spule der dünnen Trägerschicht (3) ein Schritt des Testens und/oder des Vorpersonalisierens der Chips (6, 10) folgt.

19. Verfahren nach Anspruch 14, **dadurch gekennzeichnet, dass** dem Schritt des Ausführens mehrerer Verbindungslöcher (4) durch den Streifen der Spule der dünnen Trägerschicht (3) ein Schritt des Auftragens einer dünnen klebenden Schicht auf der gesamten unteren Fläche des Streifens der Spule der dünnen Trägerschicht (3) vorausgeht.

20. Verfahren nach Anspruch 14, **dadurch gekennzeichnet, dass** dem Schritt des Tiefziehens oder des Schneidens des Streifens der Spule der Dickschicht (9) ein Schritt des Auftragens einer dünnen klebenden Schicht auf der Fläche des Streifens der Spule der Dickschicht (9) vorausgeht oder folgt, die dazu bestimmt ist, auf dem Streifen der Spule der dünnen Trägerschicht (3) befestigt zu werden.

21. Verfahren nach Anspruch 14 und 20, **dadurch gekennzeichnet, dass** dem Schritt des Tiefziehens oder Schneidens des Streifens der Spule der Dickschicht (9) und/oder dem Schritt des Auftragens einer dünnen klebenden Schicht auf der Fläche des Streifens der Spule der Dickschicht (9) ein Schritt des Auftragens eines Schutzes auf den Flächen des Streifens der Spule der Dickschicht (9) vorausgeht.

22. Verfahren nach Anspruch 14, 20 und 21, **dadurch gekennzeichnet, dass** dem Schritt des Tiefziehens oder des Schneidens des Streifens der Spule der Dickschicht (9) und/oder dem Schritt des Auftragens einer dünnen klebenden Schicht auf der Fläche des Streifens der Spule der Dickschicht (9) und oder/dem Schritt des Auftragens eines Schutzes ein Schritt der Vorpersonalisierung auf mindestens einer der Flächen des Streifens der Spule der Dickschicht (9) durch Drucken oder durch Ätzen vorausgeht.

23. Verfahren nach Anspruch 14, **dadurch gekennzeichnet, dass** dem Schritt des Tiefziehens oder des Schneidens des Streifens der Spule der Dickschicht (9) ein Schritt des Druckens eines Sicherheits- oder kosmetischen Elements durch Ätzen oder durch Drucken auf mindestens einer der Flächen des Streifens der Spule der Dickschicht (9) folgt, wobei das Sicherheits- oder kosmetische Element auf der elektronischen Chip-Vorrichtung (0) sichtbar ist, wenn die dünne Trägerschicht (3) aus durchsichtigem Material ist.

24. Verfahren nach Anspruch 15, **dadurch gekennzeichnet, dass** auf den Schritt des Auftragens eines mechanischen und/oder optischen Schutzes der mehreren Chips gegebenenfalls ein Schritt der elektrischen Personalisierung des oder der Chips mittels einer Nadelkarte oder einer kontaktlosen Antennenvorrichtung folgt, die mit einem externen Codierleser verbunden sind.

25. Verfahren nach Anspruch 24, **dadurch gekennzeichnet, dass** auf den Schritt der elektrischen Personalisierung des oder der Chips (6, 10) mittels einer mit einem externen Leser verbundenen Nadelkarte gegebenenfalls ein Schritt der Personalisierung der elektronischen Chip-Vorrichtung durch Ätzen oder durch Drucken oder durch Wärmeübertragung auf der Seite des Streifens der Spule der Dickschicht (9) folgt, der nicht am Streifen der Spule der dünnen Trägerschicht (3) befestigt ist.

26. Verfahren nach Anspruch 15, **dadurch gekennzeichnet, dass** dem Schritt des Auftragens eines mechanischen und/oder optischen Schutzes der mehreren Chips (6, 10) ein Schritt der Personalisierung der elektronischen Chip-Vorrichtung durch Ätzen oder durch Drucken oder durch Wärmeübertragung auf der unteren Seite des Streifens der Spule der dünnen Trägerschicht (3) folgt, die nicht auf der dünnen Trägerschicht (3) befestigt ist.

27. Verfahren nach Anspruch 17 und 26, **dadurch gekennzeichnet, dass** der Schritt der Personalisierung der elektronischen Chip-Vorrichtung (0) durch Ätzen oder durch Drucken oder durch Wärmeübertragung auf der unteren Seite des Streifens der Spule der dünnen Trägerschicht (3) zu irgendeinem Zeitpunkt nach dem Schritt des Befestigens des oder der Chips auf dem Streifen der Spule der dünnen Trägerschicht (3) ausgeführt wird.

28. Verfahren nach Anspruch 26 und 27, **dadurch gekennzeichnet, dass** dem Schritt der Personalisierung der elektronischen Chip-Vorrichtung durch Ätzen oder durch Drucken oder durch Wärmeübertragung auf der unteren Seite des Streifens der Spule der dünnen Trägerschicht (3) ein Schritt der Personalisierung der elektronischen Chip-Vorrichtung durch Ätzen oder durch Drucken oder durch Wärmeübertragung auf der Seite des Streifens der Spule der Dickschicht (9) folgt, die nicht an dem Streifen der Spule der dünnen Trägerschicht (3) befestigt ist.

29. Verfahren nach Anspruch 14, **dadurch gekennzeichnet, dass** auf den Schritt des Auftragens eines mechanischen und/oder optischen Schutzes der mehreren Chips ein Schritt des Aufspulens des Streifens der Spule der dünnen Trägerschicht (3) und des Streifens der Spule der Dickschicht (9) folgt, die gemäß den vorhergehenden Schritten zusammengebaut wurden.

30. Verfahren nach Anspruch 15, **dadurch gekennzeichnet, dass** auf den Schritt des Auftragens eines mechanischen und/oder optischen Schutzes der mehreren Chips (6, 10) ein Schritt des Schneidens des Streifens der Spule der dünnen Trägerschicht (3) und des Streifens der Spule der Dickschicht (9) folgt, die gemäß den vorhergehenden Schritten zu einzelnen elektronischen Chip-Vorrichtungen zusammengebaut wurden.

31. Verfahren nach Anspruch 30, **dadurch gekennzeichnet, dass** auf den Schritt des Schneidens ein Schritt des Verpackens der geschnittenen elektronischen Chip-Vorrichtungen folgt.

32. Maschine, die die Durchführung des Verfahrens nach Anspruch 14 bis 31 zur Herstellung einer elektronischen Chip-Vorrichtung (0) nach Anspruch 1 bis 13 ermöglicht, **dadurch gekennzeichnet, dass** sie mindestens die folgenden Vorrichtungen umfasst:
- eine Vorrichtung (100) zum Abspulen eines dünnen Trägerschichtstreifens (3), der auf beiden Seiten mit Leiterbahnen versehen ist;
- eine Vorrichtung (101) zum mechanischen oder Ultraschall-Tiefziehen von Verbindungslöchern;
- eine Vorrichtung (102) zum Auftragen von Kleber oder einer dünnen klebenden Schicht auf mehreren Zonen oder unteren Kontaktbereichen, die dazu bestimmt sind, einen Chip (4) aufzunehmen;
- eine Vorrichtung (103) zum Auftragen des/der Chips;
- eine Vorrichtung (1030) zum Pressen und Vernetzen des Klebers oder der Aktivierung der klebenden dünnen Schicht;
- eine Vorrichtung (105) zum Aufspulen des Streifens der dünnen Schicht mit den Chips, derart, dass die Chips sich auf der Außenseite befinden;
- eine Vorrichtung (204) zum Tiefziehen, die gegenüber der Seite des Streifens der Dickschicht (9) angeordnet ist, die die Verbindungsseite mit der dünnen Trägerschicht (3) ist;
- eine Vorrichtung (207) zum Verbinden der Dickschicht und der Trägerschicht.

33. Maschine nach Anspruch 32, **dadurch gekennzeichnet, dass** sie ferner aus Folgendem besteht:
- einer Vorrichtung (200) zum Abwickeln eines dünnen Trägerschichtstreifens (3) mit Chips;
- einer Vorrichtung (201) zum Abrollen einer Dickschicht (9);
- einer Vorrichtung (205) zum Auftragen eines Sicherheits- oder kosmetischen Elements;
- einer Vorrichtung (208) zum Auftragen eines mechanischen und/oder optischen Schutzes der Chips durch Walzen;
- einer Vorrichtung (211) zum Schneiden in einzelne elektronische Chip-Vorrichtungen.

34. Maschine nach Anspruch 32 und 33, **dadurch gekennzeichnet, dass** sie ferner aus einer Vorrichtung zum Auftragen eines Klebers oder einer Oberflächenvorbehandlung besteht.

35. Maschine nach Anspruch 32 und 34, **dadurch gekennzeichnet, dass** sie ferner aus einer Vorrichtung zum Testen und zur Vorpersonalisierung der Chips besteht.

36. Maschine nach Anspruch 32 bis 35, **dadurch gekennzeichnet, dass** sie ferner aus einer Vorrichtung (2011) zur grafischen Vorpersonalisierung auf mindestens einer der Seiten der Dickschicht (9) besteht.

37. Maschine nach Anspruch 32 bis 36, **dadurch gekennzeichnet, dass** sie ferner aus einer Vorrichtung (202) zum Auftragen einer Schutzschicht durch Walzen besteht.

38. Maschine nach Anspruch 32 bis 37, **dadurch gekennzeichnet, dass** sie ferner aus einer Vorrichtung (209) zur Personalisierung auf der Seite der Dickschicht (9), die die Seite ist, die der Verbindungsseite mit der dünnen Trägerschicht (3) entgegengesetzt ist, und/oder auf der Seite der dünnen Trägerschicht (3) besteht, die die Seite ist, die der Verbindungsseite mit der Dickschicht (9) entgegengesetzt ist.

## Claims

1. An electronic chip device (0) comprising at least:
- an electronic module including at least:
- a flexible carrier film (3) the dimensions of which corresponds to one of the dimensions of the electronic device of which the upper surface includes an upper contact pad region (5) and of which the lower surface includes at least one lower contact pad region (7), each contact pad region being extended by conductors (1, 2) connected by interconnection (4) through the carrier film (3) in an interconnection region (41) whereby at least one lower contact pad region (7) is connected to the upper contact pad region (5), the lower contact pad region or regions (7) intersecting the perimeter designed to be occupied by at least one electronic chip (6, 10) connected using flip chip technology to each lower contact pad region (7) and the lower contact pad region or regions (7) being offset with respect to the region of the carrier film (3) facing the region the perimeter of which encircles the upper contact pad region (5); the contact pad region or regions (5, 7) of the lower and upper surface and the conductors (1, 2) being of conductive material devoid of expensive component such as nickel or gold;
- a thick film (9), provided with at least one cavity (8) opposite the region which the chip of the carrier film (3) comes to face, and fixed onto at least one portion of the surface of the carrier film (3) at the side of the chip.

2. The device (0) according to claim 1, **characterized in that** the electronic chip device (0) is a smart card the upper contact pad region (5) of which is an ISO 7816 arrangement of terminals with contact pads (5) of aluminum, silver or copper for connection to an external reader.

3. The device (0) according to claim 1, **characterized in that** the electronic chip device (0) is a smart object the upper contact pad region (5) of which is a terminal arrangement in accordance with the standard adapted to the intelligent object.

4. The device (0) according to claim 1, **characterized in that** the electronic chip device (0) further includes an RFID antenna (11) adapted to come into contact by radio frequency communication with an external reader, the RFID antenna (11) being located on the lower surface of the carrier film (3).

5. The device (0) according to claim 4, **characterized in that** the upper contact pad region (5) communicates with a chip (6) dedicated to the terminal arrangement, the RFID antenna (11) communicating with a chip (10) specific to the RFID antenna (11).

6. The device (0) according to claim 4, **characterized in that** the upper contact pad region (5) and the RFID antenna (11) communicate with a chip (6) having an interpretation device which determines whether said chip (6) is in configurations allowing it to communicate with the upper contact pad region (5) or with the RFID antenna (11).

7. The device (0) according to at least one of the preceding claims, **characterized in that** the contact pads of the chip or chips (6, 10) are oriented towards the contact pad or pads (7) dedicated to the chip or chips (6, 10) of a lower surface of the carrier film (3).

8. The device (0) according to at least one of the preceding claims, **characterized in that** the carrier film (3) is of a plastic PVC, PC, PET, PETF, PETG, PP, PS, PPS material, of paper or vegetable matter allowing it to be rolled and extruded to thicknesses substantially equal to 150 µm or a combination of these materials, the thickness of said film (3) being preferably substantially equal to 50 µm.

9. The device (0) according to at least one of the preceding claims, **characterized in that** the thick film is constituted by one or several layers of PVC, ABS, PET, PETF, PETG, PP, PS, PPS or any other material allowing use in the form of a roll, or of wood, cardboard or bioplastics.

10. The device (0) according to at least one of the preceding claims, **characterized in that** the contact pad regions (5, 7) and the conductors (1, 2) of the upper and lower surfaces of the carrier film (3) are of aluminum or copper.

11. The device (0) according to at least one of the preceding claims, **characterized in that** the carrier film (3) has at least two parallel or adjacent sides of a length equal to the parallel or adjacent sides of the electronic chip device (0).

12. The device (0) according to claim 1, **characterised in that** the interconnection region (41) is offset with respect to the upper contact pad region (5) or the lower contact pad region (7) and externally of the perimeter intended for the chip or chips.

13. The device (0) according to claim 1 and 4, **characterised in that** the interconnection region (41) is offset with respect to the upper contact pad region (5) or the lower contact pad region (7) and with respect to the RFID antenna (11) as well as externally of the perimeter intended for the chip or chips.

14. A method for producing an electronic chip device (0) according to claims 1 to 13, **characterized in that** a carrier film (3) is continuously fed by at least one feed roll supplying a strip of a width at least equal to a multiple of one of the dimensions of the electronic chip device (0), the two surfaces of the strip from the roll of carrier film (3) including a series of individual conductor circuits for a plurality of electronic chip devices (0), each individual circuit being formed in such a manner that the upper surface includes a first contact pad region (5) and the lower surface includes at least one second contact pad region (7), each contact pad region being extended by conductors (1, 2) towards an interconnection region (41) whereby at least one lower contact pad region (7) is connected to the upper contact pad region (5), the lower contact pad region or regions (7) intersecting the perimeter designed to be occupied by the contacts of a chip (6, 10) connected to each lower contact pad region (7) and the lower contact pad region or regions (7) being offset with respect to the area of the carrier film (3) facing the region the perimeter of which encircles the upper contact pad region (5), and that it includes at least the following steps:
- a step of providing, in the interconnection region, a plurality of via holes (4) through the carrier film (3);
- a step of connecting the upper contact pad region (5) and the lower contact pad region or regions (7) through the via holes (4);
- a step of depositing an anisotropic conductive paste at a plurality of areas of the lower contact pad region or regions (7) of the strip of the roll of carrier film (3) designed to receive a chip;
- a step of fixing at least one chip onto the strip of the roll of the carrier film (3) at the region or regions intended to receive a chip;
- a step of putting the carrier film strip (3) into the form of a roll or rolls with the chips fixed in place;
- a step of stamping or cutting out a strip of thick film (9) of the same width as the strip or one of the dimensions of the electronic device (0) in order to obtain one or more cavities (8) at the locations of the chips (6, 10);
- a step of bringing the two strips into a position one above the other and of adhering or bonding the strip from the roll of thick film (9) onto the strip from the roll of carrier film (3) with the chips (6, 10) fixed in place.

15. The method according to claim 14, **characterized in that** the step of adhering or bonding the strip from the thick film (9) roll onto the strip from the roll of carrier film (3) with the chips fixed is followed or preceded by a step of depositing mechanical and/or optical protection for the chip (6, 10).

16. The method according to claim 14, **characterized in that** the step of connecting the upper contact pad region (5) and the lower contact pad region or regions (7) by means of via holes (4) consists of a connection by mechanical inking or riveting, ultrasound or thermal welding or by via hole (4) filling with a conductive element.

17. The method according to claim 14, **characterized in that** the step of securing the chip or chips (6, 10) onto the carrier film (3) strip from the roll consists in securing the chip or chips (6, 10) using flip chip technology.

18. The method according to one of the preceding claims, **characterized in that** the step of securing a plurality of chips (6, 10) onto the strip from the carrier film (3) roll is followed by a step of testing and/or pre-customizing the chips (6, 10).

19. The method according to claim 14, **characterized in that** the step of providing a plurality of via holes (4) through the strip from the carrier film (3) roll is preceded by a step of depositing an adhesive film over the whole of the lower surface of the strip from the carrier film (3) roll.

20. The method according to claim 14, **characterized in that** the stamping or cutting out step of the strip from the thick film (9) roll is preceded or followed by a step of depositing an adhesive film on the surface of the strip from the thick film (9) roll intended to be fixed to the strip from the carrier film (3) roll.

21. The method according to claim 14 and 20, **characterized in that** the step of stamping or cutting out the strip from the thick film (9) roll and/or the step of depositing an adhesive film on the surface of the strip from the thick film (9) roll are preceded by a step of depositing protection on the surfaces of the strip from the thick film (9) roll.

22. The method according to claim 14, 20 and 21, **characterized in that** the step of stamping or cutting out the strip from the thick film (9) roll and/or the step of depositing an adhesive film on the surface of the strip from the thick film (9) roll and/or the step of depositing protection are preceded by a step of pre-customizing on at least one of the surfaces of the strip from the thick film (9) roll using printing or etching.

23. The method according to claim 14, **characterized in that** the step of stamping and/or cutting out the strip from the thick film (9) roll is followed by a step of printing a security or cosmetic element using etching or printing on at least one of the surfaces of the strip from the thick film (9) roll, the security or cosmetic element being visible on the electronic chip device (0) if the carrier film (3) is of a transparent material.

24. The method according to claim 15, **characterized in that** the step of depositing mechanical and/or optical protection for the plurality of chips is optionally followed by a step of electrical customizing of the chip or chips using an array of pins or a contact-less antenna device connected to an external reader/encoder.

25. The method according to claim 24, **characterized in that** the step of electrical customization of the chip or chips (6, 10) using an array of pins connected to an external reader is optionally followed by a step of customizing the electronic chip device using etching or printing or thermal transfer onto the face of the strip from the thick film (9) roll which is not secured onto the strip from the carrier film (3) roll.

26. The method according to claim 15, **characterized in that** the step of depositing mechanical and/or optical protection for the plurality of chips (6, 10) is followed by a step of customizing the electronic chip device using etching or printing or thermal transfer onto the lower face of the strip from the carrier film (3) roll which is not fixed onto the carrier film (3).

27. The method according to claim 17 and 26, **characterized in that** the step of customizing the electronic chip device (0) using etching or printing or thermal transfer onto the lower face of the strip from the carrier film (3) roll is performed at any time whatsoever after the step of fixing the chip or chips onto the strip from the carrier film (3) roll.

28. The method according to claims 26 and 27, **characterized in that** the step of customizing the electronic chip device by etching or printing or by thermal transfer onto the lower face of the strip from the carrier film (3) roll is followed by a step of customizing the electronic chip device using etching or printing or thermal transfer onto the face of the strip from the thick film (9) roll which is not fixed onto the strip from the carrier film (3) roll.

29. The method according to claim 14, **characterized in that** the step of depositing mechanical and/or optical protection for the plurality of chips is followed by a step of winding the strip from the carrier film (3) roll and the strip from the thick film (9) roll assembled according to the preceding steps, into a roll.

30. The method according to claim 15, **characterized in that** the step of depositing mechanical and/or optical protection for the plurality of chips (6, 10) is followed by a step of cutting out the strip from the carrier film (3) roll and the strip from the thick film (9) roll assembled according to the preceding steps into individual electronic chip devices.

31. The method according to claim 30, **characterized in that** the step of cutting out is followed by a step of packaging the electronic chip devices that have been cut out.

32. A machine for carrying out the method according to claims 14 to 31 for the production of the electronic chip device (0) according to claims 1 to 13, **characterized in that** it includes at least the following devices:
- a device (100) for unwinding a strip of carrier film (3) provided with conductive tracks on both faces;
- device (101) for mechanical or ultrasound stamping;
- a device (102) for depositing bonding agent or adhesive film onto a plurality of regions or lower contact pads intended to receive a chip (4);
- a device (103) for depositing a chip or chips;
- a device (1030) for pressing and cross-linking the bonding agent or for activating the adhesive film;
- a device (105) for winding the strip of film with the chips into a roll in such a manner that the chips are at the outside;
- a device (204) for stamping arranged facing that face of the strip of thick film (9) which is the face to be joined to the carrier film (3);
- a device (207) for joining together the two thick and carrier films.

33. The machine according to claim 32, **characterized in that** it further includes:
- a device (200) for unwinding a strip of carrier film (3) carrying chips;
- a device (201) for unwinding a thick film (9);
- a device (205) for depositing a security or cosmetic element;
- a device (208) for depositing by rolling, mechanical and/or optical protection for the chips;
- a device (211) for cutting out into individual electronic chip devices.

34. The machine according to claims 32 and 33, **characterized in that** it further includes a device for depositing bonding agent or a surface preparation agent.

35. The machine according to claims 32 and 34, **characterized in that** it further includes a device for chip testing and pre-customization.

36. The machine according to claims 32 to 35, **characterized in that** it further includes a device (2011) for graphical pre-customization on at least one of the faces of the thick film (9).

37. The machine according to claims that 32 to 36, **characterized in that** it further includes a device (202) for depositing a protective layer by rolling.

38. The machine according to claims 32 to 37, **characterized in that** it further includes a device (209) for customization on the face of the thick film (9) which is that face opposing the face for joining with the carrier film (3) and/or on the face of the carrier film (3) which is the face opposing the face for joining to the thick film (9).
